# EUROPEAN PATENT APPLICATION

(11) **EP 4 814 518 A1**
(43) Date of publication of application: **30.09.2026**
(21) Application number: 25166094.0
(22) Date of filing: 25.03.2025
(51) Int. Cl.: G01R 33/09

(54) **MAGNETIC FIELD TRANSDUCER**

(71) Applicant: TDK Corporation, Tokyo 103-6128 (JP)
(72) Inventor: TIMOPHEEV, Andrey, 38450 VIF (FR); SCHLÄFLI, Dominik, 1260 NYON (CH)
(74) Representative: Epping - Hermann - Fischer

(57) **Abstract**

A magnetic field transducer (1) comprising a tunnel magnetoresistance (TMR) sensing arrangement (2) comprising a TMR Wheatstone bridge (4) and a power supply, wherein the TMR Wheatstone bridge comprise a plurality of TMR sensing branches (5), wherein at least one TMR sensing branch comprises a plurality of magnetic tunnel junction (MTJ) elements (8), said MTJ elements being coupled via conducting elements (7), wherein said MTJ elements comprise a plurality of first MTJ elements (9) having a first shape and a plurality of second MTJ elements (11) having a second shape, wherein, said first MTJ elements are configured to exhibit controlled vortex states with counterclockwise or clockwise chirality and said second MTJ elements are configured to exhibit controlled vortex states with counterclockwise or clockwise chirality, wherein the first MTJ elements and the second MTJ elements have opposite remanences with respect to each other.

## Description

### Field

The present invention relates to a magnetic field transducer comprising a TMR sensing arrangement.

### Background

A magnetic field transducer with a tunnel magnetoresistance (TMR) sensing arrangement has been used for magnetic field sensing. The TMR sensing arrangement typically involves multiple TMR elements configured in a Wheatstone bridge. When an external magnetic field is applied, the resistances of the TMR elements change. This change generates a voltage difference of output terminals of the TMR Wheatstone bridge, which is proportional to the strength of the applied magnetic field.

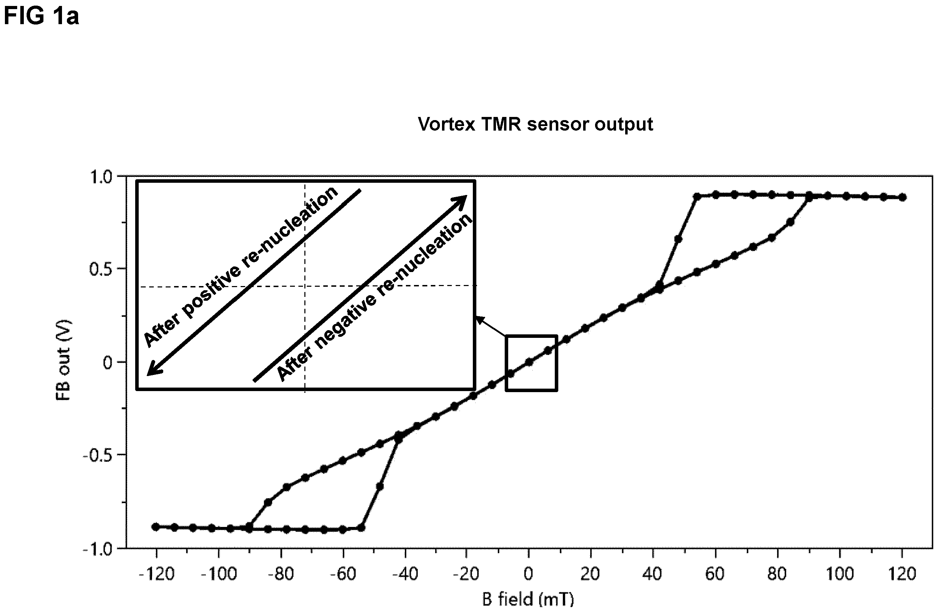

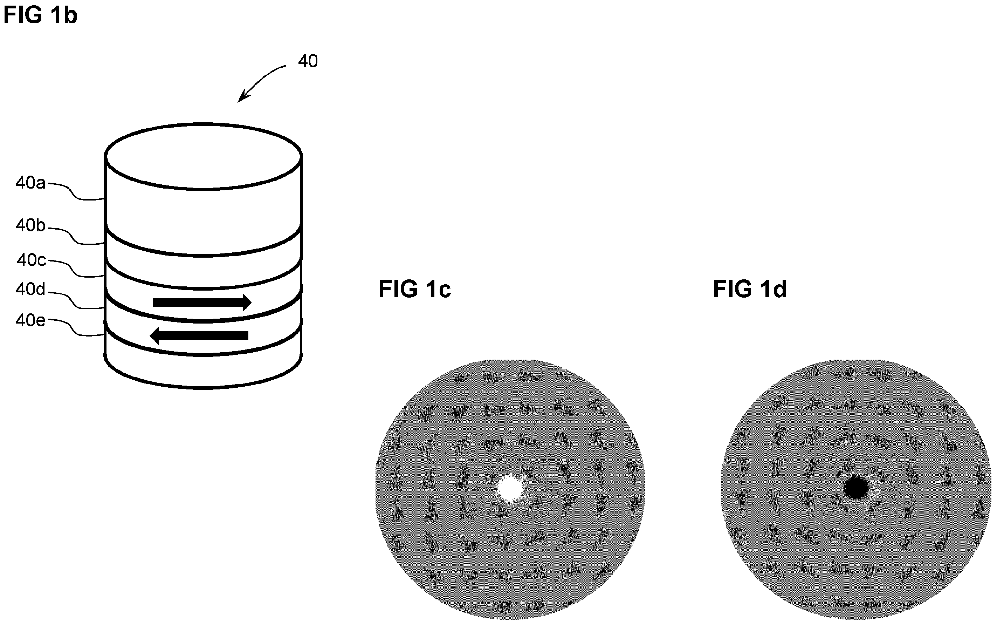

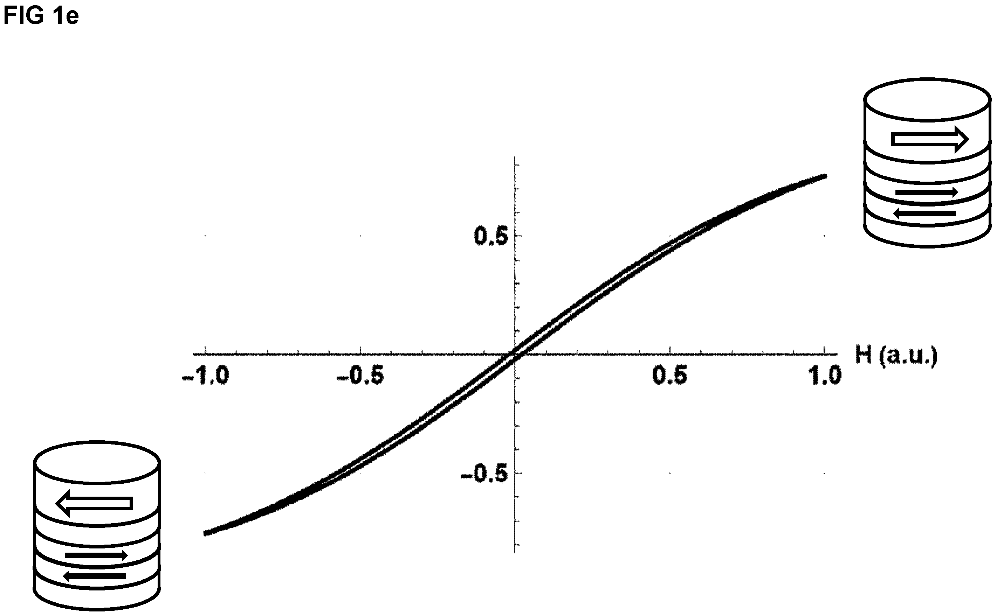

Figure 1 illustrates a graph showing the output voltage changes of a TMR Wheatstone bridge in response to a varying applied magnetic field. Generally, the TMR Wheatstone bridge provides good linearity with respect to the applied magnetic field. However, within the transition zone-between the annihilation and nucleation field points-a hysteretic loop is observed, as shown in Figure 1, due to the magnetic transition between these states.

Additionally, as depicted in the magnified view in Figure 1, while the output voltage of the TMR Wheatstone bridge should ideally be zero when no external magnetic field is present, a non-zero offset voltage can be observed. This offset results from the hysteresis during the transition between annihilation and nucleation, leading to residual magnetization and a non-zero output in the zero-field region. Over time, this offset voltage exhibits a shift, typically lying in the millivolt range per volt of TMR sensor bias voltage. This shift negatively impacts the accuracy of the TMR sensing arrangement by introducing measurement errors.

### Summary

In view of the foregoing, it is an object of the invention to provide a magnetic field transducer comprising a TMR sensing arrangement which is accurate.

It is advantageous to provide a magnetic field transducer that is economical to produce and operate.

It is advantageous to provide a magnetic field transducer that is stable and reliable.

It is advantageous to provide a magnetic field transducer that is easy to implement.

Objects of the invention have been achieved by providing a magnetic field transducer according to claim 1.

Dependent claims set out various advantageous features of embodiments of the invention.

Disclosed herein is a magnetic field transducer comprising a tunnel magnetoresistance (TMR) sensing arrangement comprising a TMR Wheatstone bridge and a power supply, the TMR Wheatstone bridge comprising a plurality of TMR sensing branches each comprising a plurality of magnetic tunnel junction (MTJ) elements interconnected via conducting elements

The MTJ elements comprise a plurality of first MTJ elements having a first shape and a plurality of second MTJ elements having a second shape, said first MTJ elements being configured to exhibit controlled vortex states with counterclockwise or clockwise chirality and said second MTJ elements being configured to exhibit controlled vortex states with counterclockwise or clockwise chirality, and the first MTJ elements and the second MTJ elements have opposite remanences with respect to each other.

In an advantageous embodiment, an edge-to-edge distance between any of two neighboring MTJ elements is equal or greater than a largest diameter of the MTJ elements.

In an advantageous embodiment, the first shape comprises a first non-centrosymmetric structure and the second shape comprises a second non-centrosymmetric structure.

In an advantageous embodiment, the first shape and the second shape are identical.

In an advantageous embodiment, said at least one TMR sensing branch comprises one resistor chain, or a plurality of resistor chains connected in parallel, each resistor chain formed of a plurality of said MTJ elements connected in series.

In an advantageous embodiment, at least one said resistor chain comprises a plurality of said first MTJ elements and a plurality of said second MTJ elements.

In an advantageous embodiment, the first MTJ elements and the second MTJ elements of the resistor chain are alternatingly arranged.

In an advantageous embodiment, said plurality of resistor chains include at least a first resistor chain comprising a plurality of said first MTJ elements and at least a second resistor chain comprising a plurality of said second MTJ elements, said first and second resistor chains disposed parallel and adjacent each other.

In an advantageous embodiment, said at least one TMR sensing branch further comprises a second resistor chain comprising at least one of said second MTJ elements.

In an embodiment, said MTJ elements further comprise a plurality of third MTJ elements having a third shape and a plurality of fourth MTJ elements having a fourth shape, wherein, said third MTJ elements exhibit controlled vortex states with counterclockwise or clockwise chirality and said fourth MTJ elements exhibit controlled vortex states with counterclockwise or clockwise chirality, wherein said third MTJ elements and said fourth MTJ elements have opposite remanences with respect to each other.

In an advantageous embodiment, the third shape and the fourth shape are non-centrosymmetric.

In an advantageous embodiment, said at least one resistor chain further comprises a plurality of said third MTJ elements.

In an advantageous embodiment, said at least one resistor chain further comprises a plurality of said fourth MTJ elements.

In embodiments, the Wheatstone bridge may have two, three, or four of said TMR sensing branches each comprising said plurality of MTJ elements having said first and second shapes.

In an embodiment, at least one of the sensing branches of the Wheatstone bride may comprise or constitute a fixed resistor.

Further advantageous features of the invention will be apparent from the following detailed description of embodiments of the invention and the accompanying illustrations.

### Brief description of the figures

Figure 1a is a diagram presenting an output of a TMR Wheatstone bridge in response to an applied magnetic field according to prior art;
Figure 1b shows a magnetic tunnel junction (MTJ) element according to prior art;
Figure 1c shows a vortex magnetic state with a clockwise chirality and a positive core polarity in a sense layer of a multilayer MTJ element according to prior art;
Figure 1d shows a vortex magnetic state with a counter-clockwise chirality and a negative core polarity in a sense layer of a multilayer MTJ element according to prior art;
Figure 1e shows a diagram of conductivity of an MTJ element in response to an applied magnetic field according to prior art;
Figure 2a is a schematic diagram of a magnetic field transducer according to an embodiment of the invention;
Figure 2b is a schematic diagram of a first MTJ element with a vortex formation biased to clockwise chirality of a TMR Wheatstone bridge of a magnetic field transducer according to an embodiment of the invention;
Figure 2c is a schematic diagram of a second MTJ element with a vortex formation biased to counterclockwise chirality of a TMR Wheatstone bridge of a magnetic field transducer according to an embodiment of the invention;
Figure 2d is a schematic diagram of a first MTJ element with a vortex formation biased to clockwise chirality of a TMR Wheatstone bridge of a magnetic field transducer according to an embodiment of the invention;
Figure 2e is a schematic diagram of a second MTJ element with a vortex formation biased to counterclockwise chirality of a TMR Wheatstone bridge of a magnetic field transducer according to an embodiment of the invention;
Figure 3a is a schematic illustration of a TMR Wheatstone bridge of a magnetic field transducer according to an embodiment of the invention;
Figure 3b is a schematic illustration of a TMR sensing branch comprising a plurality of sensing branches of a TMR Wheatstone bridge of a magnetic field transducer according to an embodiment of the invention;
Figure 4a is a schematic top view of a centrosymmetric MTJ element according to prior art;
Figure 4b is a schematic top view of a first MTJ element comprising a first non-centrosymmetric structure of a TMR Wheatstone bridge of a magnetic field transducer according to an embodiment of the invention;
Figure 4c is a schematic perspective view of a first MTJ element comprising a first non-centrosymmetric structure of a TMR Wheatstone bridge of a magnetic field transducer according to an embodiment of the invention;
Figure 4d is a bar chart showing generation probabilities of clockwise and counter-clockwise chiralities as a function of length of a partial diameter of a non-centrosymmetric MTJ element;
Figure 4e shows a graph of an absolute value of coercive field of sensing layer of a non-centrosymmetric MTJ element as a function of length of its partial diameter b;
Figure 4f shows a graph of a normalized remanent magnetization of a sensing layer of a non-centrosymmetric MTJ element as a function of length of its partial diameter b;
Figure 4g shows a graph of a magnetization of a centrosymmetric MTJ element according to prior art as a function of an applied magnetic field and a magnetization of a first MTJ element of a TMR Wheatstone bridge of a magnetic field transducer according to an embodiment of the invention as a function of the applied magnetic field;
Figure 5a shows a graph of a magnetization of a resistor chain comprising a series of a plurality of first MTJ elements of the TMR Wheatstone bridge of a magnetic field transducer according to an embodiment of the invention as a function of an applied magnetic field;
Figure 5b shows a graph of a magnetization of a resistor chain comprising a series of a plurality of second MTJ elements of the TMR Wheatstone bridge of a magnetic field transducer according to an embodiment of the invention as a function of an applied magnetic field;
Figure 5c shows a graph of a magnetization of the two resistor chains in Figure 5a and 5b, electrically coupled in parallel, as a function of an applied magnetic field;
Figures 6a-6c show an example of fabricating a first MTJ element of a magnetic transducer according to an embodiment of the invention;
Figures 7a-7d shows different TMR sensing branches of the magnetic field transducers according to embodiments of the invention.

### Descriptions

Referring to the figures, a magnetic field transducer 1 according to embodiments of the invention comprises a TMR sensing arrangement 2 and a power supply 3. The power supply 3 is configured to supply power to the TMR sensing arrangement 2. The TMR sensing arrangement 2 comprises a TMR Wheatstone bridge 4. The TMR Wheatstone bridge 4 comprises a plurality of TMR sensing branches 5. At least one TMR sensing branch 5a comprises a plurality of magnetic tunnel junction (MTJ) elements 8. The MTJ elements are electrically coupled via conductive elements 7.

The MTJ elements 8 comprises a plurality of first MTJ elements 9 and a plurality of second MTJ elements 11. The first MTJ elements 9 have a first shape and the second MTJ elements have a second shape, respectively. The first MTJ elements 9 are configured to exhibit reproducible vortex states biased toward a first chirality, either clockwise (CW) or counter clockwise (CCW) chirality. The second MTJ elements 11 are configured to exhibit reproducible vortex states biased toward a second chirality, either CCW or CW chirality. Depending on positive or negative re-nucleation, the first chirality and the second chirality can be switched, e.g, from CW chirality to CWW chirality. In addition, the first MTJ elements 9 and the second MTJ elements 11 exhibit opposite zero-field remanences relative to each other after vortex re-nucleation event happened. The first and the second MTJ elements 9, 11 either exhibits opposite chirality relative to each other or identical chirality; however, the zero-field remanences of the first and the second MTJ elements 9, 11 are identical in magnitude but opposite in sign. A chirality direction of a vortex is established during the vortex re-nucleation process and remains conserved until a vortex annihilation event occurs. After re-nucleation, the sum of zero-field remanences of MTJ elements 9 and MTJ elements 11 remains zero, resulting in zero-hysteresis response at an output of the magnetic field transducer 1.

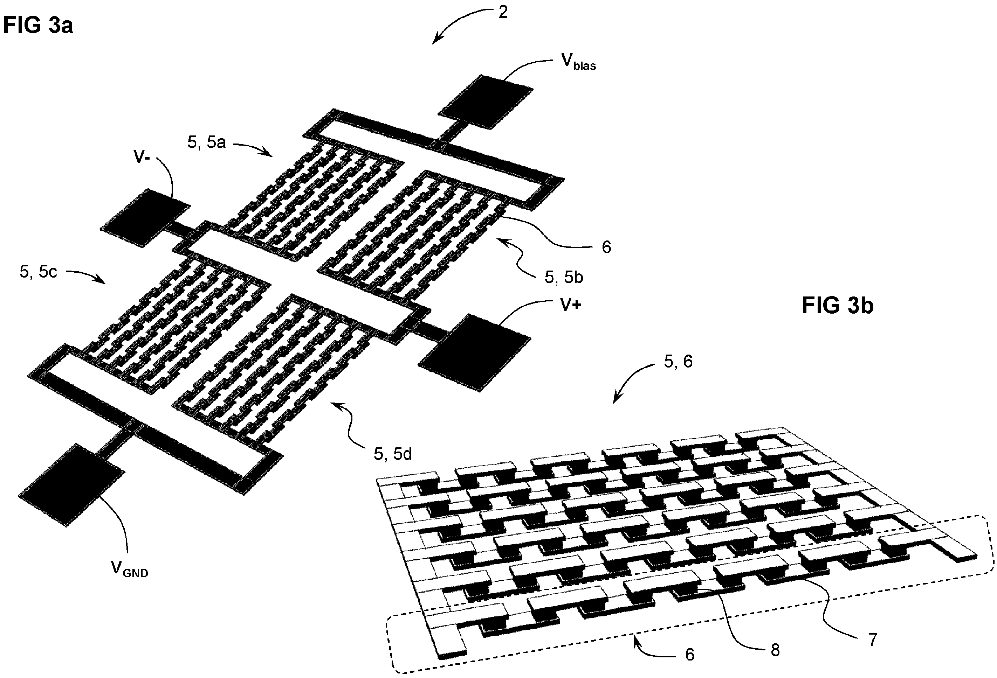

The TMR Wheatstone bridge 4 may be an electrical circuit in which four TMR sensing branches 5, 5a-5d forms a symmetrical quadrilateral shape with four sides as shown in Figure 3a. The TMR sensing branches 5 may be connected at four junctions or nodes. For instance, the first and the second TMR branches 5a, 5b forms a node corresponding to a voltage bias terminal V_{bias}. The first and the third TMR sensing branches 5a, 5c forms a node corresponding to a negative output terminal V-. The second and the fourth TMR sensing branches 5b, 5d forms a node corresponding to a positive output terminal V+. The third and the fourth TMR sensing branches 5c, 5d form a node corresponding to a ground terminal **V_{GND}.** The output voltage of the TMR Wheatstone bridge 4 may be measured across the negative and the positive output terminals V-, V+.

Referring to Figures 1a - 1e, the figures show a TMR Wheatstone bridge output as a function of an applied or external magnetic field and a multilayer MTJ pillar 40 according to prior art. The multilayer MTJ pillar 40 is typically formed into a centrosymmetric shape such as a circular or elliptical cylinder, pillar, or disk shape and comprises, from top to bottom, a sensing layer 40a, a tunnel barrier 40b, a reference layer 40c, a pinned layer 40d, and an antiferromagnetic layer 40e, shown in Figure 1b, as known *per se.* In the absence of an external magnetic field, a magnetization of the sense layer 40a forms an in-plane circular vortex state. This vortex state can exhibit four combinations of chirality (CW or CWW) and core polarity (positive or negative), where the core polarity points out-of-plane (up or down) relative to a sense layer. Figure 1c illustrates a vortex state in the sense layer 40a of the multilayer MTJ pillar 40 with a CW chirality and positive polarity, while Figure 1d shows in the sense layer 40a of the multilayer MTJ pillar 40 with a CCW chirality and negative polarity.

It is known that the vortex state disappears at the annihilation field and reforms at the nucleation field (i.e., re-nucleation) in a vortex MTJ pillar. Vortex re-nucleation follows a complex, nonlinear process. Starting from a saturated state, magnetization reversal initiates at the dot periphery, where multiple domain walls with varying geometry and chirality propagate toward the center. These domain walls separate oppositely magnetized regions, and their interactions-including changes in size, mutual repulsion, and annihilationfacilitate the formation of transient local vortices with random chirality. Subsequently, multiple vortices may form, but only one remains in the final magnetic state. This process is highly stochastic, influenced by thermal fluctuations, local demagnetizing fields, dot geometry, edge irregularities, and/or various factor as known *per se.* Additionally, it is sensitive to the direction of an applied field and magnetostatic interactions with neighboring MTJ pillars.

Therefore, when a vortex state reforms during re-nucleation, its chirality can become randomized due to its inherent stochastic nature. This chirality randomness affects hysteresis by disrupting vortex lattice configurations, leading to increased magnetic hysteresis. In magnetic skyrmions, such randomness results in asymmetric hysteresis behavior in magnetization curves. If re-nucleation after external field cycling leads to different skyrmion chirality states, the system deviates from its original magnetization path, broadening the hysteresis loop.

On the other hand, the magnetic field transducer 1 according to embodiments of the invention provides a way to control chirality of vortex formation using the first MTJ elements 9 comprising the first shape and the second MTJ elements 11 comprising the second shape as each shape is configured to exhibit reproducible vortex state with either CW or CWW chirality. Moreover, the first MTJ elements 9 and the second MTJ elements 11 exhibit opposite zero-field remanences. Therefore, the magnetic field transducer 1 can result in a reduced zero-shift error during re-nucleation by compensating the hysteresis and reducing stochastic generation of vortex states with CW and CCW chirality.

Preferably, the number of the first MTJ elements and the second MTJ elements are identical. Therefore, within the magnetic transducer 1, a population of vortex states with opposite remanent magnetizations is balanced.

Each MTJ element 8 comprises a plurality of layers comprising a sense layer 8a. Each MTJ element 8 further comprises a tunneling barrier 8b, a reference layer 8c, a pinned layer 8d, and an antiferromagnetic layer 8e. Similarly, each first MTJ element 9 comprises a plurality of layers comprising a sense layer 10a and each second MTJ element 11 comprises a plurality of layers comprising a sense layer 12a. Each first MTJ element 9 further comprises a tunneling barrier 10b, a reference layer 10c, a pinned layer 10d, and an antiferromagnetic layer 10e. Each second MTJ element 11 further comprises a tunneling barrier 12b, a reference layer 12c, a pinned layer 12d, and an antiferromagnetic layer 12e.

The first shape comprises a first non-centrosymmetric structure and the second shape comprises a second non-centrosymmetric structure. The first and second non-centrosymmetric structures include any truncated centrosymmetric structures.

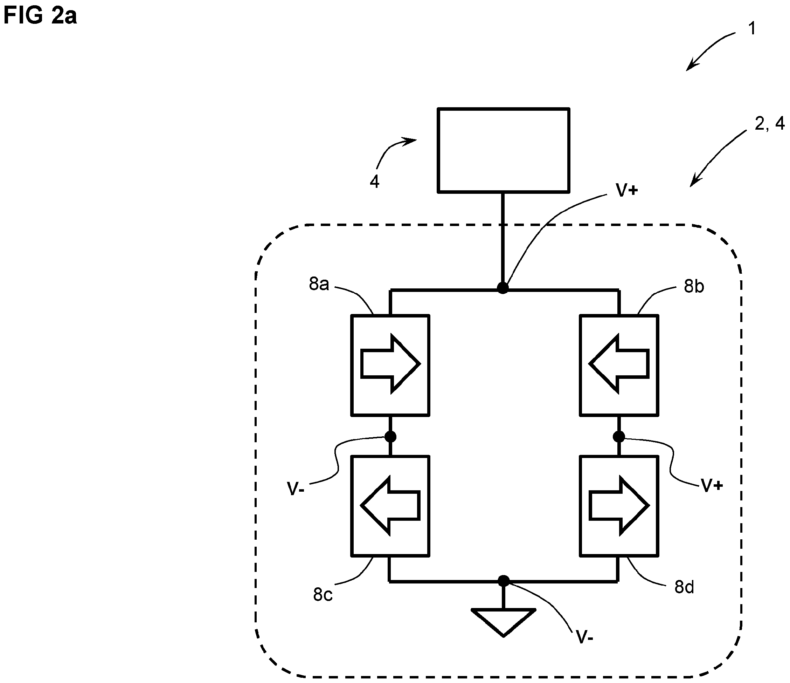

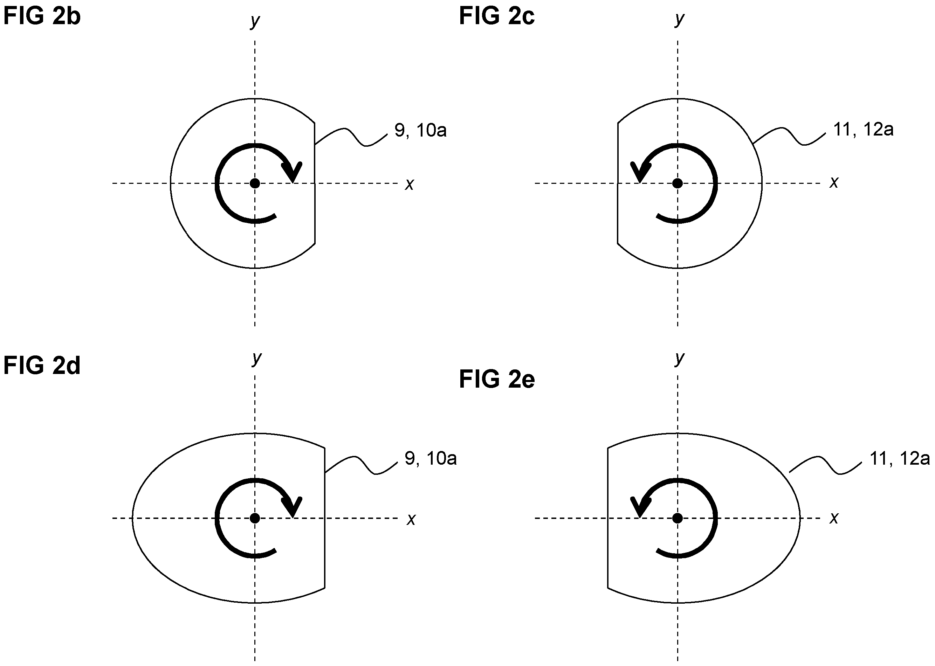

In an example, the first and second non-centrosymmetric structures may be truncated circular or elliptical cylinders (e.g. cylinder, pillar, or disk). The truncated circular or elliptical cylinders are circular or elliptical cylinders that are intersected by a plane at least once or multiple times. Preferably, a plane may pass through at least two points on the top surface (i.e. the sense layers 9a, 12a) of a circular or elliptical cylinder, such that the respective circle or ellipse positioned on the top of the respective circular or elliptical cylinder is truncated or segmented. Advantageously, the truncated circular or elliptical cylinders can be circular or elliptical cylinders that are intersected longitudinally along their height or length at least once or multiple times. Referring to Figures 2b-2e, 4b-c, 6a-c, the figures illustrate various examples of the first non-centrosymmetric structure of the first MTJ elements 9 or the second non-centrosymmetric structure of the second MTJ elements 11.

Notably, a circular cylinder is a special case of an elliptical cylinder where the major and minor axes of the ellipse are equal. Therefore, even if a circular cylinder is not explicitly mentioned, an elliptical cylinder includes a circular cylinder.

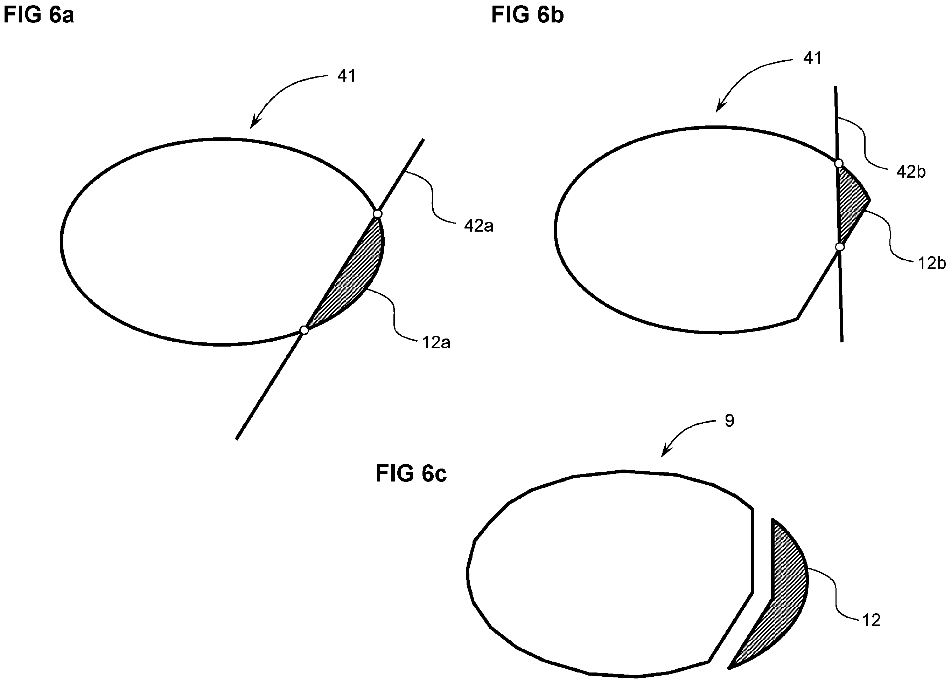

Figures 6a - 6c show a method to provide a non-centrosymmetric structure, which can be applied to the first non-centrosymmetric structure of the first MTJ elements 9 or the second non-centrosymmetric structure of the second MTJ elements 11 of the TMJ Wheatstone bridge of the magnetic field transducer 1 according to an embodiment of the invention.

As described above, the first non-centrosymmetric structure can be formed by segmenting any existing centrosymmetric structure. Figure 6a shows that an MTJ element 41 comprising an elliptical cylindrical structure according to prior art is segmented by a segmentation plane 42a perpendicular to its sense layer. A first removed portion 12a of the MTJ element 41 is marked with a diagonal striped pattern. As shown in figure 6b, using a second segmentation plane 42b perpendicular to the sense layer of the MTJ element 41 according to prior art, the MTJ element 41 can be further segmented by removing a second portion12b of the MTJ element 41.

Figure 6c shows the first non-centrosymmetric structure of the first MTJ elements 9 presenting the removed portion 12, the sum of the first and second removed portion 12a, 12b according to an embodiment of the invention.

During a fabrication process of the first or the second MTJ elements 9, 11, the segmentation of the centrosymmetric structure can be performed by anisotropic etching existing centrosymmetric MTJ elements according to prior art. Alternatively, the first or second non-centrosymmetric structure can be formed directly during a photolithography step of nanofabrication of the first and/or the second MTJ elements 9, 11, as known *per se.*

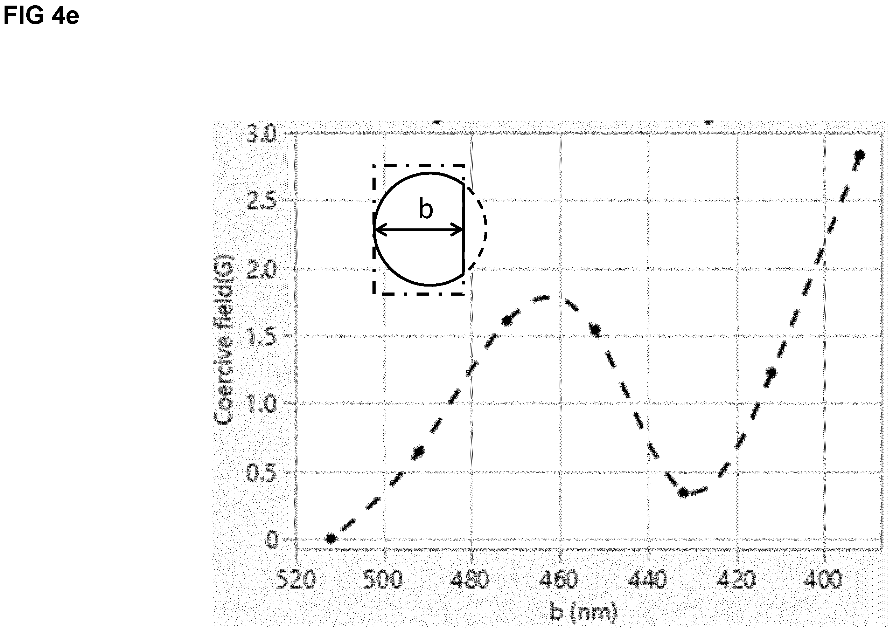

As described above in relation to Figure 1b, MTJ elements according to prior art are typically formed into centrosymmetric shapes, such as elliptical cylinder or disk. Therefore, after re-nucleation, the probability of vortex formation with CW or CCW chirality is arbitrary for each MTJ element. The generation probabilities for CW and CCW chiralities are primarily driven by magnetic and fabrication process-introduced irregularities which might not be equal over the MTJ elements ensemble. Additionally, stochastic behavior arising from thermal fluctuations of magnetization introduces randomness and irreproducibility. Consequently, these factors collectively contribute to the hysteretic response and zero-shift as shown in Figure 1a. As demonstrated in Figure 4e, the non-centrosymmetric shape can enforce a desired vortex chirality (either CW or CWW) and suppress the stochastic nature of the vortex re-nucleation process.

The first shape and the second shape may be identical. Considering the sense layers 10a, 12a of the first MTJ elements 9 and the second MTJ elements 11 are positioned in the same plane, by rotating the second MTJ elements relative to the first MTJ elements 9 by 180°, the second MTJ elements 11 and the first MTJ elements 11 can have the opposite chirality. Figures 2b - 2d schematically demonstrate the opposite chirality of the first MTJ elements 9 and the second MTJ elements 11 by rotating the second MTJ elements 11 relative to the first MTJ elements 9 according to embodiments of the invention.

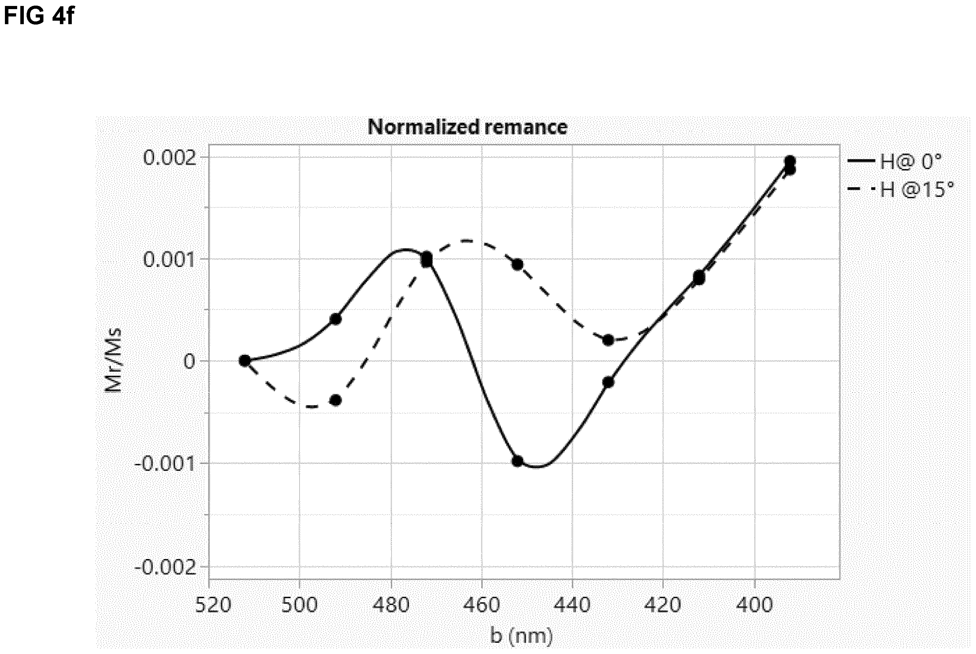

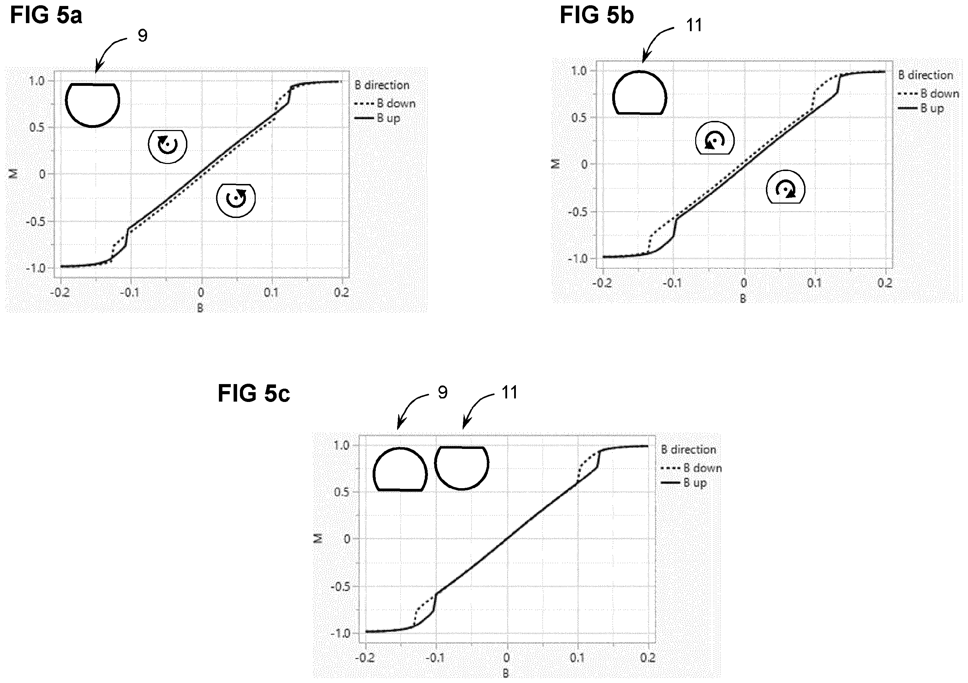

The rotation angle of the second MTJ elements 11 related to the first MTJ elements 9 can range from 0° to 180°. Depending on in-plane rotation angle (i.e. the x-y plane in Figures 2b-2e) between 0° to 180°, the apparent in-plane chirality of the first MTJ element 9 or the second MTJ element 11 can change or remain identical. As described above, the first and the second chiralities of the first and the second MTJ elements 9, 11 can be identical while the zero-field remanences of the first and the second MTJ elements 9, 11 are identical in magnitude but opposite in sign such that the sum of the zero-field remanences remains zero (see Figure 4f, Figures 5a-5c).

In contrast to centrosymmetric structures, the vortex formation process in non-centrosymmetric structures can be more deterministic. In the application, a non-centrosymmetric ratio ris defined using a ratio between a removed portion of a corresponding centrosymmetric structure and the centrosymmetric structure, where 0 < *r <* 1. When the non-centrosymmetric ratio *r* equals to zero, it means it is centrosymmetric.

For instance, the non-centrosymmetric ratio r can be a ratio between a top surface area of removed portion of a centrosymmetric structure and a top surface area of the centrosymmetric structure. Alternatively, the non-centrosymmetric ratio r can be a ratio between a longest length of a segment, perpendicular to a section line, of a removed portion of a top surface area of corresponding centrosymmetric structure and a length of a longest segment, perpendicular to the section line, of the top surface of the centrosymmetric structure. The higher the non-centrosymmetric ratio r, the larger the portion of the centrosymmetric structure that is removed (segmented or truncated). When the non-centrosymmetric ratio *r* is higher a vortex chirality bias threshold, an MTJ element comprising a non-centrosymmetric shape can exhibit a vortex chirality bias, favoring either CW or CCW. The vortex chirality bias threshold can vary depending on dimensions of MTJ elements.

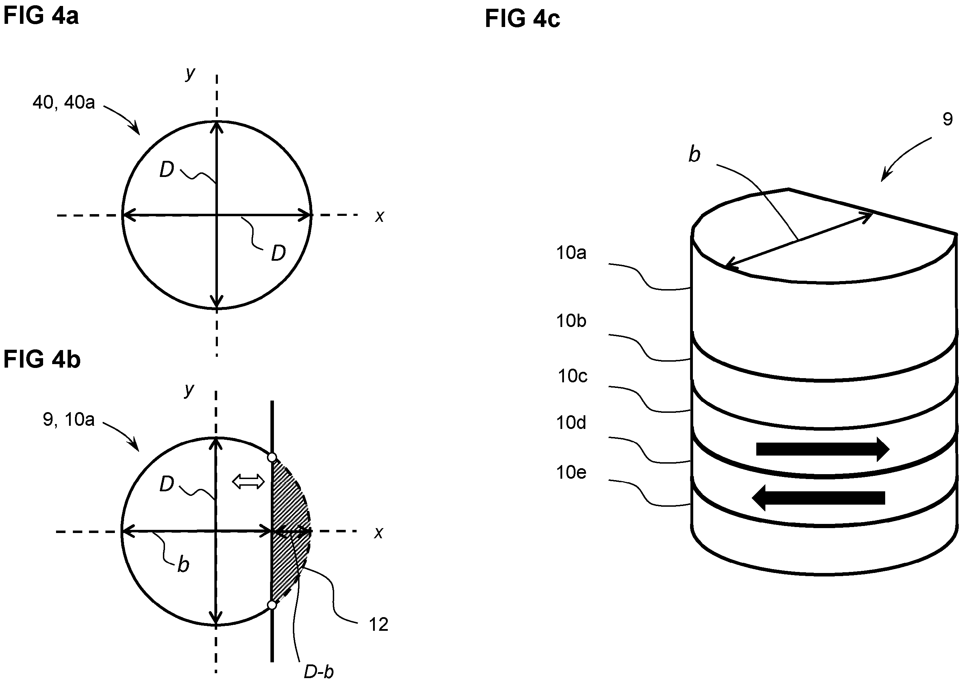

Referring to Figures 4a-4g, the figures demonstrate a relation between the non-centrosymmetric ratio r and corresponding chirality of vortex states and remanence of the first MTJ element 9 according to an embodiment of the invention.

Figure 4a shows the top surface of the sense layer 40a with a diameter D of the MTJ pillar 40 as a reference centrosymmetric MTJ element according to prior art as described above in relation to Figure 1b.

Figure 4b shows a top surface of the sense layer 10a of the first MTJ element 9 according to an embodiment of the invention. Figure 4c shows a perspective view of the first MTJ element 9 according to the embodiment.

In this embodiment, the first MTJ element 9 comprises the first non-centrosymmetric structure, which is analogous to a longitudinally truncated circular cylinder with a diameter D along z-axis (not shown). In other words, the first non-centrosymmetric structure is identical to a truncated version of the centrosymmetric circular cylindrical structure of the MTJ pillar 40, as if the first non-centrosymmetric structure is obtained by segmenting the MTJ pillar 40 along its length, perpendicular to the surface of the sense layer 40a and parallel to y-axis. A partial diameter b of the first shape is defined as a longest distance between any two points in the surface of the sense layer 10a of the first MTJ element 9 along x-axis, where 0 < *b < D*. A removed diameter *q* is defined as *q* = *D-b,* where 0 < *q* < *D*.

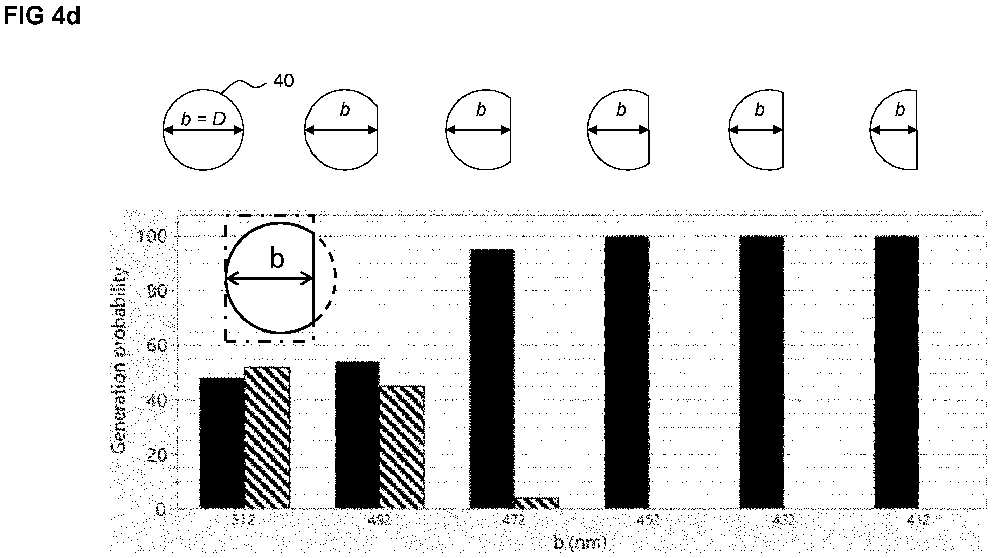

Figure 4d shows a bar chart showing simulation results of generation probabilities of CW and CCW chiralities as a function of the partial diameter b of the first MTJ elements 9 in Figures 4a and 4b. Finite-temperature (T=300K) Landau-Lifshitz-Gilbert simulations are performed using a 512 nm diameter (i.e., D = 512 nm) permalloy disc with 128 nm thickness as a reference, equivalent to the MTJ pillar 40 according to prior art. As the partial diameter b decreases from 512 nm to 412 nm by 20 nm, removed portion or segment of the reference disk increases. The probability of vortex formation of CW chirality is shown as a solid block bar and the probability of vortex formation of CCW chirality is shown as a diagonal stripes bar.

The relation between the non-centrosymmetric ratio *r* and generation probabilities of CW and CW vortex chiralities is demonstrated in Figure 4d. The MTJ pillar 40 according to prior art shows uncontrolled approximately equal 50/50% probabilities of CW and CCW vortex chirality formations. In addition, remanence of the MTJ pillar 40 is uncontrolled and can be positive or negative causing either positive or negative zero shift (not shown). As described above, due to the inherent stochastic nature of vortex reformation in an MTJ pillar according to prior art, the generation probabilities of CW and CCW chiralities are arbitrary and undetermined. Therefore, the zero-shift error of the TMR Wheatstone bridge output according to prior art is affected by the stochasticity of prenucleation process with the randomized chiralities of vortex states within the TMR Wheatstone bridge.

On the other hand, by gradually increasing the removed diameter q by 20 nm, generation probabilities of vortex states with CW chirality increases.

For this embodiment, for simplification, the non-centrosymmetric ratio r is calculated as a ratio between the removed diameter q and the diameter D (512 nm) of the surface of the sense layer 10a of the MTJ pillar 40. Therefore, the partial diameters b of the first non-centrosymmetric structure correspond to the non-centrosymmetric ratios r of 0, 0.04, 0.08, 0.12, 0.16, and 0.20, respectively. Based on the CW chirality generation probability in Figure 4d, the vortex chirality bias threshold can be set at 0.12 or b = 452 nm.

Figure 4e shows an absolute value of coercivity of a non-centrosymmetric MTJ element as a function of its partial diameter *b* within a range from 512 nm to 392 nm by 20 nm similar to Figure 4d. The non-centrosymmetric ratio *r* affects the coercivity of the non-centrosymmetric MTJ element.

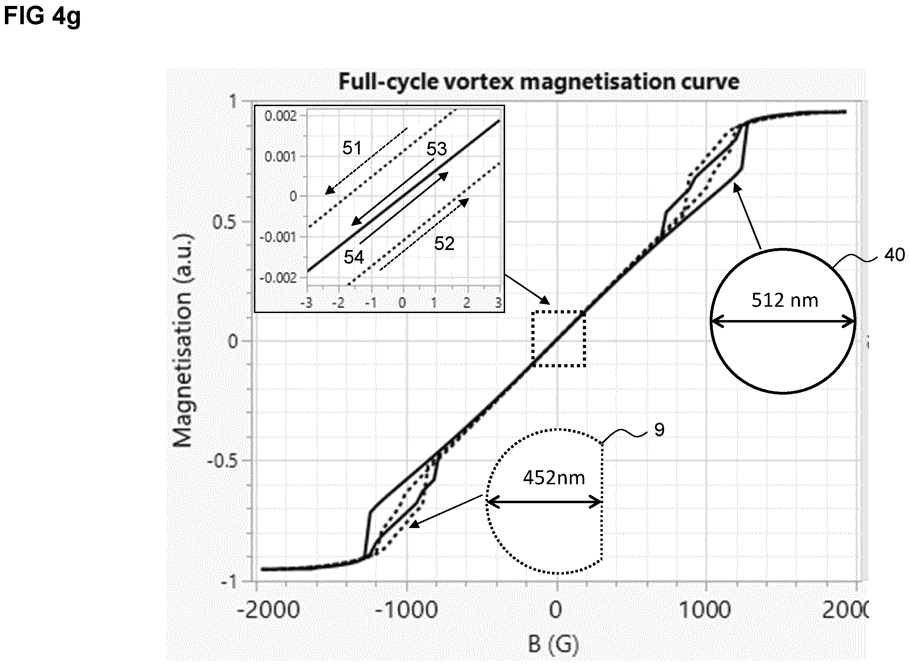

Figure 4f demonstrates simulation results of normalized zero-field remanences of the non-centrosymmetric MTJ element in Figure 4e as a function of its partial diameter *b.* The normalized zero-field remanences of the non-centrosymmetric MTJ element after removal of an external magnetic field applied along the direction of the partial diameter *b* as shown in Figure 4b is illustrated in sold line. The normalized zero-field remanences of the non-centrosymmetric MTJ element after removal of the external magnetic field applied at a 15° angle with respect to the direction of the partial diameter *b* is illustrated in dashed line. Therefore, Figure 4f shows that in-plane rotation of the non-centrosymmetric MTJ element can change sign of the remanence of the non-centrosymmetric MTJ element. For instance, the second MTJ elements 11 are identical to the first MTJ elements 9 but rotated in-plane by 15° relative to the first MTJ elements 9 as described above. Then, the first and the second MTJ elements 9, 11 can exhibit vortex states of the same chirality but show opposite remanent magnetizations as shown in Figure 4g.

Figure 4g shows a graph of a magnetization of the MTJ pillar 40 with the diameter *D* of 512 nm according to prior art and the embodiment of the first MTJ element 9 with the partial diameter *b* of 452 nm as described above as a function of an applied magnetic field in solid line and dotted lines, respectively. In a magnified view of Figure 4g, the first MTJ element 9 with the partial diameter *b* of 452 nm shows a positive zero-shift 51 during negative re-nucleation and a negative zero-shift 52 during positive re-nucleation.

However, for instance, the relative in-plane rotation angle of 15° between the first and the second MTJ elements 9, 11 and the partial diameter *b* of 452 nm of the first MTJ element 9 can be chosen based on the coercivity and the normalized remanence graphs in Figures 4e and 4f. Even though the non-centrosymmetric ratio *r* affects the coercivity of the non-centrosymmetric MTJ element, as the first MTJ elements 9 and the second MTJ elements 11 have opposite remanences, the zero-field shift at the output of the TMR Wheatstone bridge 4 can be cancelled as shown in Figures 5a-5c.

Depending on geometry of the first and the second non-centrosymmetric structures, corresponding non-centrosymmetric ratio *r* of each non-centrosymmetric structure and/or relative in-plane rotation angle between the first MTJ elements 9 and second MTJ element 11 can vary such that the first MTJ elements 9 and the second MTJ elements 11 result in reproducible vortex states with the first or second chirality, respectively, during re-nucleation while having opposite remanence magnetizations relative to each other to cancel out the zero-shift as described above.

Magnetostatic interactions between neighboring MTJ elements can affect vortex state (i.e. chirality during re-nucleation and/or remanence) of MTJ elements. These magnetostatic interactions can be avoided or minimized by adjusting a distance between two neighboring MTJ elements 8. The distance between any two neighboring MTJ elements 8 can be at least equal or greater than a largest diameter of the MTJ elements 8 or at least of a largest diameter of a non-truncated version of the first or the second non-centrosymmetric structure.

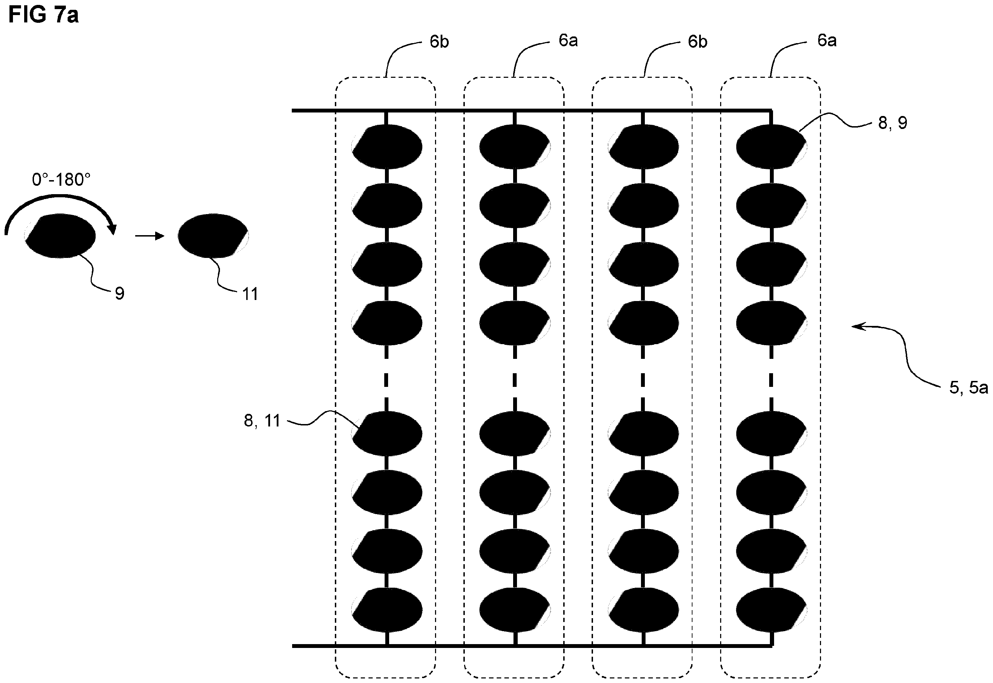

Referring to Figures 7a-c, the at least one TMR sensing branch 5, 5a comprises the first MTJ elements 9 and the second MTJ elements 11. The first MTJ elements 9 and the second MTJ elements 11 exhibit reproducible vortex states of the first and the second chiralities respectively and show the zero-field remanences identical in magnitude but opposite in signs resulting in the cancellation of hysteresis of the output of the TMR Wheatstone bridge 4 as shown in Figure 5c. While maintaining controlled re-nucleation process and zero total remanence, various arrangements of the first MTJ elements 9 and the second MTJ elements 11 may be used in different embodiments of the magnetic field transducer 1 according to the invention. As there are numerous ways to couple the first MTJ elements 9 and the second MTJ elements 11 in series or parallel within the at least one TMR sensing branch 5a, not all possible combinations of series and/or parallel arrangements of each MTJ element are listed.

The at least one TMR sensing branch 5, 5a comprises at least one resistor chain 6, 6a (hereafter "the first resistor chain"). The first resistor chain 6a comprises at least portion of the MTJ elements 8. The at least portion of the MTJ elements 8 are coupled via the conductive elements 7 in series. The at least portion of the MTJ elements 8 comprises at least one of the first MTJ elements 9.

The first resistor chain 6a may further comprises a portion of the first MTJ elements 9. In such cases, the first resistor chain 6a exhibit vortex states biased to CW chirality. In an example, the first resistor chain 6a further comprises a portion of the second MTJ elements 11 such that the vortex chirality is controlled within the first resistor chain 6a.

The at least one TMR sensing branch 5, 5a may further comprises a second resistor chain 6b. The second resistor chain 6b comprises a portion of the second MTJ element 11. In such cases, the second resistor chain 6b exhibit controlled vortex state with the opposite remanence. The second resistor chain 6b may further comprises a portion of the first MTJ element 9 such that the vortex states with CW and CC chirality are balanced within the second resistor chain 6b.

The MTJ elements 8 may further comprise a plurality of third MTJ elements 13 and a plurality of fourth MTJ elements 15. The third MTJ elements 13 comprises a third shape. The fourth MTJ elements 16 comprises a fourth shape. In addition, the third MTJ elements 13 exhibits reproducible vortex states biased towards CW or CCW chirality and the fourth MTJ elements 15 exhibits reproducible vortex states biased towards CW or CCW chirality while the third MTJ elements 13 and the fourth MTJ elements have opposite remanences with respect ot each other to provide total zero remanence to cancel the hysteresis typical to non-centrosymmetric MTJ element analogous to what is described for the first and the second MTJ elements 9, 11 above.

The third shape comprises a third non-centrosymmetric structure. The fourth shape comprises a fourth non-centrosymmetric structure. The third shape and the four shape are different from the first shape and the second shape in their dimensions such that rotating the first shape or second cannot result in any of the third shape or the fourth shape.

Preferably, the third shape and the fourth shape are identical. Considering the sense layers of the third MTJ elements and the fourth MTJ elements are positioned in the same plane, by rotating the fourth MTJ elements relative to the third MTJ elements 13 by an in-plane rotation angle between 0° and 180°, the fourth MTJ elements 15 and the third MTJ elements 13 can have vortex states with the opposite remanences similar to the first and the second MTJ elements 9, 11 above.

The first resistor chain 6a may further comprise at least one of the third MTJ elements 13. Additionally, the first resistor chain 6a may further comprise a portion of the third MTJ elements 13.

The first resistor chain 6a may further comprise at least one of the fourth MTJ elements 15. Additionally, the first resistor chain 6a may further comprise a portion of the fourth MTJ elements 15.

The second resistor chain 6b may further comprise at least one of the third MTJ elements 13. The second resistor chain 6b may further comprise a portion of the third MTJ elements 13.

The second resistor chain 6b may further comprises at least one of the fourth MTJ elements 15. The second resistor chain 6b may further comprise a portion of the third MTJ elements 13.

The at least one TMR branch 5a may further comprise a third resistor chain 6c comprising at least one of the third MTJ elements. The third resistor chain 6c is coupled to the first and the second resistor chains 6a, 6b in parallel. The third resistor chain 6c may comprises a portion of the third MTJ elements 13 in series.

The third resistor chain 6c may further comprises a portion of the fourth MTJ elements 15 in series.

The at least one TMJ branch 5a may further comprise a fourth resistor chain 6d comprising at least one of the fourth MTJ elements. The fourth resistor chain is coupled to the third resistor chain 6c in parallel.

The fourth resistor chain 6d may further comprises a portion of the fourth MTJ elements in series. Additionally, the fourth resistor chain 6d may further comprises a portion of the third MTJ elements in series.

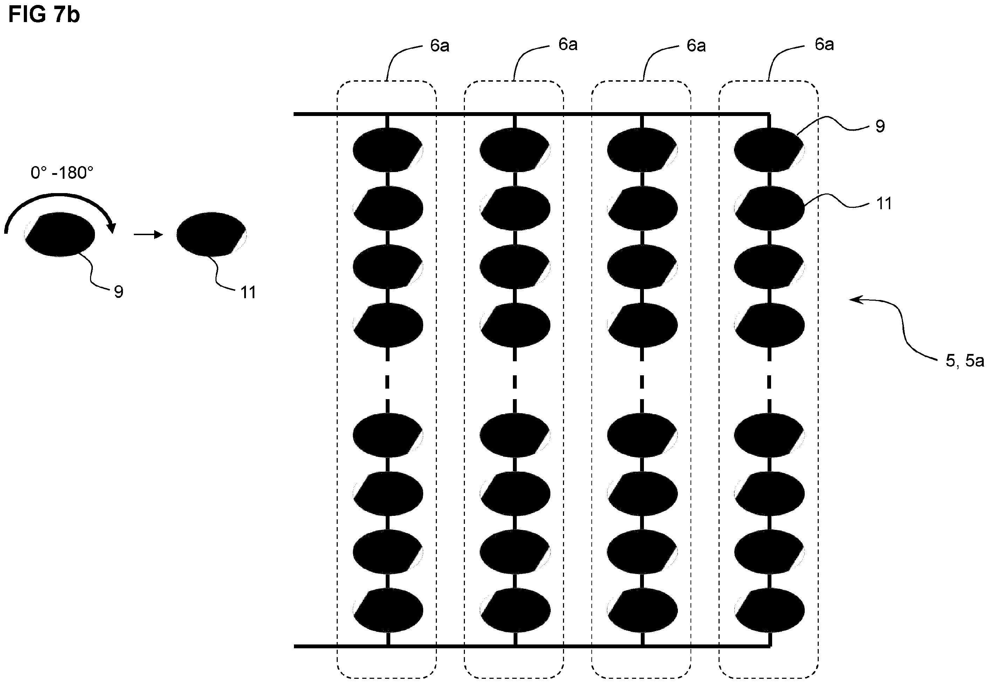

Referring to Figure 7b, in an embodiment, the first resistor chain 6a may comprise a portion of the first MTJ elements 9 in series. The first resistor chain may further comprise a portion of the second MTJ elements 11 in series. In such cases, the first resistor chain 6a exhibit vortex states biased toward CW and CWW chirality such that a population of vortex states chirality is controlled while the total remanence magnetization within the first resistor chain 6a remains zero as the first MTJ elements 9 and the second MTJ elements 11 exhibit opposite remanent magnetizations with respect to each other analogous to Figure 5c. Figure 5c shows the zero-shift error of the output of the TMR Wheatstone bridge is cancelled out due to the balanced to zero remanence and controlled vortex chirality generation within the first resistor chain 6a, which can compensate the shift of the magnetizations to the opposite directions (negative and positive) respectively.

Within the first resistor chain 6a, the portion of the first MTJ elements 9 and the portion of the second MTJ elements 11 may be arranged such that the portion of the first MTJ elements 9a are followed by the portion of the second MTJ elements. In another example, the first MTJ element 9 and the second MTJ element 11 may be positioned sequentially following an alternating pattern. Alternatively, two of first MTJ elements 9 may be followed by two of second MTJ elements 11 or the potion of the first MTJ elements 9 are followed by the portion of the second MTJ elements 11 in order. This is a non-exhaustive list of permutation of the first and second MTJ elements 9, 11 within the first resistor chain 6a. Any order of arrangements of the first and second MTJ elements 9, 11 can be used based on the formula for the permutation.

As shown in Figure 7b, the at least one TMR branch 5a of the TMR Wheatstone bridge 4 may comprises a plurality of the first resistor chains 6a coupled in parallel. Notably, as the first resistor chain 6a has balanced to zero remanence of and controlled vortex chirality, the number of resistor chains comprised in the at least one TMR branch 5a can be any natural number.

Referring to Figure 7a, in an embodiment, the first resistor chain 6a may comprise a portion of the first MTJ elements 9 in series. The at least one TMR sensing branch 5, 5a further comprises a second resistor chain 6b comprising a portion of the second MTJ elements 9 in series. The second resistor chain 6b is coupled to the at least one resistor chain 6a in parallel via the conductive elements 7.

In Figure 7a, one of each first MTJ elements 9 and the second MTJ elements 11 are shown. As described above, the first MTJ elements 9 and the second MTJ elements 11 can be identical but the second MTJ elements 11 are rotated by an in-plane rotational angle between 0° and 180° about an axis perpendicular to their sense layers 12a relative to the first MTJ elements, such that the second MTJ elements still provide vortex states with controlled chirality but generate opposite remanence at zero field as illustrated in Figures 5a-5c.

In the embodiment, the first resistor chain 6a and the second resistor chain 6b exhibit vortex states with controlled chirality. Figures 5a, 5b show their respective magnetization curves which possess opposite remanence states at zero field. Since the first resistor chain 6a and the second resistor chain 6b are coupled in parallel, the at least one TMR sensing branch 5, 5a has a balanced to zero remanence and controlled chirality similar to Figure 7a. Therefore, the hysteresis in the output of the TMR Wheatstone bridge 4 will be cancelled as shown in Figure 5c.

Additionally, the at least one TMR sensing branch 5, 5a may further comprises one or more pair of the first resistor chain 6a and the second resistor chain 6b as described above such that the number of the first resistor chains 6a and the second resistor chains 6b are identical to remain the balanced to zero remanence and control over vortex chiralities. Figure 7a shows that resistor chain comprising the first MTJ elements 9 and the resistor chain comprising the second MTJ elements 10 are arranged alternatively. However, the arrangement of the first resistor chains 6a and the second resistor chains 6b within the at least one TMR sensing branch 5a may vary according to the permutation formula.

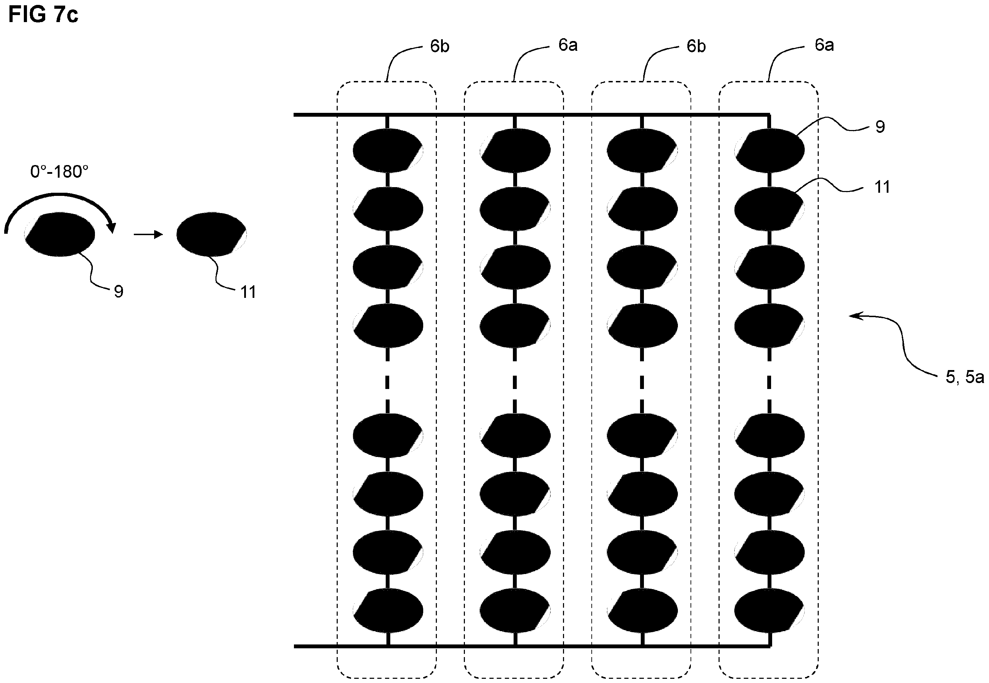

Referring to Figure 7c, in an embodiment, the at least one TMR branch 5a comprises the first resistor chain 6a and the second resistor chain 6b. The first resistor chain 6a comprises a portion of first MTJ elements 9 and a portion of second MTJ elements 11 in series. The first resistor chain 6a exhibit remanence states equally balanced such that a population of vortex states with opposite remanence within the first resistor chain 6b is balanced analogous to Figure 5c. Similarly, the second resistor chain 6b comprises a portion of the first MTJ elements 9 and a portion of the second MTJ elements 11 in series. Therefore, a population of vortex states with opposite remanence and controlled chirality within the second resistor chain 6b is balanced as well.

In Figure 7a, the at least one TMR branch 5a comprises two pairs of the first resistor chain 6a comprising both the first and the second MTJ elements 9, 11 sequentially but alternating manner and the second resistor chain 6b comprising both the second and the first MTJ elements 11, 9 sequentially but the opposite order to the first resistor chain 6a. Each resistor chain has balanced population of vortex states with opposite remanence values. Each MTJ element in each resistor chain is positioned such that it is adjacent to respective MTJ element(s) exhibiting vortex state with the opposite remanence in parallel. However, any order of arrangements of the first MTJ elements 9 and the second MTJ elements 11 within the first resistor chain 6a or the second resistor chain 6b can be used based on the formula for the permutation. Notably, the arrangements of the first MTJ elements 9 and the second MTJ elements 11 in the first resistor chain 6a and the second resistor chain 6b differ from each other while the vortex states with opposite remanence in each resistor chain 6a, 6b remains balanced.

Additionally, the at least one TMR branch 5a may further comprises a plurality of the first resistor chains 6a and the second resistor chains 6b. As each resistor chain has the balanced to zero remanence of vortex states, the number of the first resistor chains 6a and the number of the second resistor chains 6b might not be identical.

Analogous to what is described for the first and the second resistor chain 6a, 6b, various arrangements of the third and fourth MTJ elements 13, 15 within the third resistor chain 6c or the fourth resistor chain 6d are possible according to the permutation.

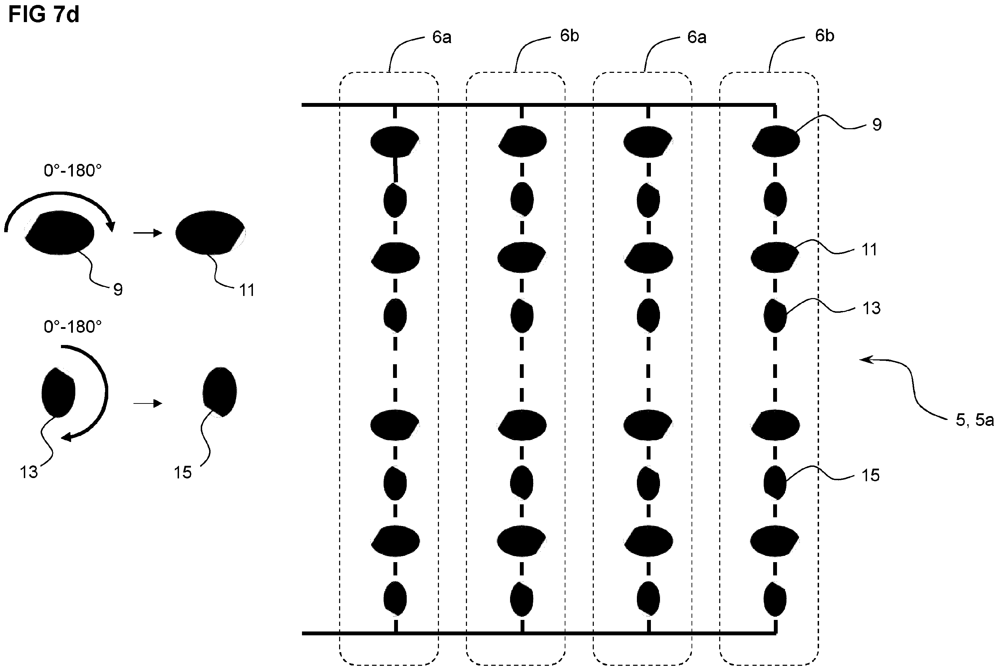

Figure 7d shows the at least one TMR branch 5a of the TMR Wheatstone bridge 4 of the magnetic field transducer 1 according to a fourth embodiment of the invention.

In this embodiment, the at least one TMR branch 5a comprises two pairs of the first resistor chain 6a comprising the first, the third, the second, and the fourth MTJ elements 9, 13, 11, 15 and the second resistor chain 6b comprising the second, the third, the first, and the fourth elements 11, 13, 9, 15. In this embodiment, within the first resistor chain 6a, the first, the third, the second, and the fourth MTJ elements are arranged sequentially in a repeating pattern. Within the second resistor chain 6b, the second, the third, the first, and the fourth elements 11, 13, 9, 15 are arranged sequentially in a repeating pattern.

Similar to Figures 7b and 7c, each resistor chain has balanced population of reproducible vortex states with opposite remanences. However, each MTJ element in each resistor chain is spaced such that it is adjacent to respective MTJ element(s) exhibiting controlled vortex state with the opposite remanences in parallel.

In all the embodiment and further possible combinations, it is preferable that the edge-to-edge distance between any of two neighboring MTJ elements 8 is equal or greater than a largest diameter of the MTJ elements 8 to avoid substantial magnetostatic interaction between the MTJ elements 8 such that corresponding chiralities of vortex states or or remanences of the first and the second MTJ elements 9, 11 are not affected by their magnetostatic interactions caused by proximity between two neighboring MTJ elements 8.

### List of references

**Magnetic field transducer 1**
**TMR sensing arrangement 2**
   TMR Wheatstone bridge 4
   TMR sensing branch 5
      Resistor string/chain 6
      Conductive element 7
      MTJ element 8
         First MTJ element 9
            Sense layer 10a
            Tunneling barrier 10b
            Reference layer 10c
            Pinned layer 10d
            Antiferromagnetic layer 10e
         Second MTJ element 11
            Sense layer 12a
            Tunneling barrier 12b
            Reference layer 12c
            Pinned layer 12d
            Antiferromagnetic layer 12e
         Third MTJ element 13
         Fourth MTJ element 15
   Voltage bias terminal V_{bias}
   Ground terminal V_{GND}
   Positive output terminal V+
   Negative output terminal V-
Power supply 3
External circuit 30

## Claims

1. **A magnetic field transducer (1)** comprising a tunnel magnetoresistance (TMR) sensing arrangement (2) comprising a TMR Wheatstone bridge (4) and a power supply, the TMR Wheatstone bridge comprising a plurality of TMR sensing branches (5) each comprising a plurality of magnetic tunnel junction (MTJ) elements (8) interconnected via conducting elements (7), wherein said MTJ elements comprise a plurality of first MTJ elements (9) having a first shape and a plurality of second MTJ elements (11) having a second shape, said first MTJ elements being configured to exhibit controlled vortex states with counterclockwise or clockwise chirality and said second MTJ elements being configured to exhibit controlled vortex states with counterclockwise or clockwise chirality, and the first MTJ elements and the second MTJ elements have opposite remanences with respect to each other.

2. The transducer of claim 1, wherein an edge-to-edge distance between any of two neighboring MTJ elements is equal or greater than a largest diameter of the MTJ elements.

3. The transducer of any preceding claim, wherein the first shape comprises a first non-centrosymmetric structure and the second shape comprises a second non-centrosymmetric structure.

4. The transducer of any preceding claim, wherein the first shape and the second shape are identical.

5. The transducer of any preceding claim, wherein said at least one TMR sensing branch comprises one resistor chain, or a plurality of resistor chains connected in parallel, each resistor chain formed of a plurality of said MTJ elements connected in series.

6. The transducer of the preceding claim, wherein at least one said resistor chain comprises a plurality of said first MTJ elements and a plurality of said second MTJ elements.

7. The transducer of the preceding claim, wherein the first MTJ elements and the second MTJ elements of the resistor chain are alternatingly arranged.

8. The transducer of any preceding claim, wherein said plurality of resistor chains include at least a first resistor chain comprising a plurality of said first MTJ elements and at least a second resistor chain comprising a plurality of said second MTJ elements, said first and second resistor chains disposed parallel and adjacent each other.

9. The transducer of any preceding claim, wherein said at least one TMR sensing branch further comprises a second resistor chain comprising at least one of said second MTJ elements.

10. The transducer of any preceding claim, wherein said MTJ elements further comprise a plurality of third MTJ elements having a third shape and a plurality of fourth MTJ elements having a fourth shape, wherein, said third MTJ elements exhibit controlled vortex states with counterclockwise or clockwise chirality and said fourth MTJ elements exhibit controlled vortex states with counterclockwise or clockwise chirality, wherein said third MTJ elements and said fourth MTJ elements have opposite remanences with respect to each other.

11. The transducer of any preceding claim, wherein the third shape and the fourth shape are non-centrosymmetric.

12. The transducer of any preceding claim 10-11 in conjunction with claim 5, wherein said at least one resistor chain further comprises a plurality of said third MTJ elements.

13. The transducer of any preceding claim 10-12 in conjunction with claim 5, wherein said at least one resistor chain further comprises a plurality of said fourth MTJ elements.

14. The transducer of any preceding claim, wherein there are two, three, or four said TMR sensing branches each comprising said plurality of MTJ elements having said first and second shapes.

15. The transducer of any preceding claim, wherein the Wheatstone bridge comprises at least one sensing branch constituting a fixed resistor.
